# EUROPEAN PATENT APPLICATION

(11) **EP 4 701 359 A1**
(43) Date of publication of application: **25.02.2026**
(21) Application number: 25197203.0
(22) Date of filing: 21.08.2025
(51) Int. Cl.: H05K 7/20

(54) **POWER CONVERSION DEVICE AND ENERGY STORAGE CABINET**

(30) Priority: 21.08.2024 CN 202422041635 U
(71) Applicant: Huawei Digital Power Technologies Co., Ltd., Shenzhen, Guangdong 518043 (CN)
(72) Inventor: HAO, Yuwei, Shenzhen, Guangdong, 518043 (CN); LI, Jiyang, Shenzhen, Guangdong, 518043 (CN); JIN, Shuqun, Shenzhen, Guangdong, 518043 (CN); WU, Hao, Shenzhen, Guangdong, 518043 (CN)
(74) Representative: Maiwald GmbH

(57) **Abstract**

The present disclosure provides a power conversion device and an energy storage cabinet, and pertains to the field of power conversion technologies. The power conversion device includes a housing, a power plate, and a liquid cooling plate. The power plate is located inside the housing. One side of the power plate includes a plurality of power conversion modules, and the other side of the power plate is attached to the liquid cooling plate. The inside of the liquid cooling plate includes a first main channel, at least two branch channels, and a second main channel. Two ends of each branch channel respectively communicate with the first main channel and the second main channel. In a direction perpendicular to the liquid cooling plate, projections of at least two of the plurality of power conversion modules at least partially overlap projections of the different branch channels. In this way, heat dissipation of the power conversion modules corresponding to the different branch channels does not affect each other. This avoids or reduces impact of thermal cascading, and improves heat dissipation efficiency of the power conversion modules.

## Description

### TECHNICAL FIELD

The present disclosure relates to the field of power conversion technologies, and in particular, to a power conversion device and an energy storage cabinet.

### BACKGROUND

With development of the new energy industry, a power of a power conversion device continuously increases, and power consumption of a power plate inside the power conversion device also continuously increases.

To meet a heat dissipation requirement of the power conversion device, a liquid cooling plate is disposed in the power conversion device in a related technology. The liquid cooling plate is attached to the power plate, so that heat dissipated by a plurality of power conversion modules on the power plate can be dissipated through coolant in the liquid cooling plate.

However, the liquid cooling plate in the related technology cannot effectively dissipate heat for all power conversion modules on the power plate, and heat dissipation efficiency of some power conversion modules is low.

### SUMMARY

The present disclosure provides a power conversion device and an energy storage cabinet. A liquid cooling plate of the power conversion device includes a plurality of branch channels disposed in parallel. In addition, at least two of the plurality of power conversion modules and different branch channels are disposed opposite to each other, so that heat dissipation of the two power conversion modules does not affect each other, and the two power conversion modules have high heat dissipation efficiency. Technical solutions of the power conversion device and the energy storage cabinet are described as follows.

According to a first aspect, the present disclosure provides a power conversion device. The power conversion device includes a housing, a power plate, and a liquid cooling plate. The power plate is located inside the housing. One side of the power plate includes a plurality of power conversion modules, and the other side of the power plate is attached to the liquid cooling plate. The inside of the liquid cooling plate includes a first main channel, at least two branch channels, and a second main channel. Two ends of each branch channel respectively communicate with the first main channel and the second main channel. In a direction perpendicular to the liquid cooling plate, projections of at least two of the plurality of power conversion modules at least partially overlap projections of the different branch channels.

The power conversion device provided in the present disclosure is a power conversion system (power conversion system, PCS), an inverter, or the like.

According to the technical solution provided in the present disclosure, the liquid cooling plate includes a plurality of branch channels disposed in parallel. In addition, in the direction perpendicular to the liquid cooling plate, the projections of the at least two power conversion modules overlap the projections of the different branch channels, so that coolant in the different branch channels separately takes away heat of the at least two power conversion modules. In this way, heat dissipation of the power conversion modules corresponding to the different branch channels does not affect each other. This reduces impact of thermal cascading, and improves heat dissipation efficiency of the power conversion modules.

In an implementation, the plurality of power conversion modules include a phase-A power conversion module, a phase-B power conversion module, and a phase-C power conversion module. The inside of the liquid cooling plate includes three branch channels. In the direction perpendicular to the liquid cooling plate, a projection of the phase-A power conversion module, a projection of the phase-B power conversion module, and a projection of the phase-C power conversion module at least partially overlap projections of the three branch channels respectively. In this way, the coolant separately flows through regions corresponding to the phase-A power conversion module, the phase-B power conversion module, and the phase-C power conversion module, and separately takes away heat of the phase-A power conversion module, the phase-B power conversion module, and the phase-C power conversion module. In this way, heat dissipation of one power conversion module is not affected by the heat dissipated by the other two power conversion modules. This reduces impact of thermal cascading, and improves heat dissipation efficiency of the phase-A power conversion module, the phase-B power conversion module, and the phase-C power conversion module.

In an implementation, the coolant in the liquid cooling plate sequentially flows through the first main channel, the three branch channels, and the second main channel. The plurality of power conversion modules further include a phase-N power conversion module. In the direction perpendicular to the liquid cooling plate, a projection of the phase-N power conversion module at least partially overlaps a projection of the first main channel. Power consumption of the phase-N power conversion module is higher than power consumption of the phase-A power conversion module, the phase-B power conversion module, and the phase-C power conversion module. In this way, the coolant first flows through a region corresponding to the phase-N power conversion module, and then separately flows through the regions corresponding to the phase-A power conversion module, the phase-B power conversion module, and the phase-C power conversion module. In this way, heat dissipation of the phase-N power conversion module is not affected by heat dissipation of the other three power conversion modules. This helps ensure heat dissipation effect of the phase-N power conversion module with highest power consumption.

In an implementation, the coolant in the liquid cooling plate sequentially flows through the first main channel, the three branch channels, and the second main channel. The one side of the power plate further includes a balanced circuit and an anti-reverse module. In the direction perpendicular to the liquid cooling plate, a projection of the balanced circuit and a projection of the anti-reverse module at least partially overlap the projection of the first main channel. Power consumption of the balanced circuit and the anti-reverse module is far lower than power consumption of the power conversion module. In this way, the coolant first flows through regions corresponding to the balanced circuit and the anti-reverse module, and then flows through the regions corresponding to the phase-A power conversion module, the phase-B power conversion module, and the phase-C power conversion module. In this way, heat dissipation of the balanced circuit and the anti-reverse module is not affected by the heat dissipated by the phase-A power conversion module, the phase-B power conversion module, and the phase-C power conversion module. In addition, because power consumption of the balanced circuit and the anti-reverse module is far lower than power consumption of the power conversion module, heat dissipated by the balanced circuit and the anti-reverse module causes a small temperature increase of the coolant, and also has small impact on heat dissipation of the phase-A power conversion module, the phase-B power conversion module, and the phase-C power conversion module.

In an implementation, the liquid cooling plate further includes three first turbulence members and a second turbulence member. The three first turbulence members are respectively located on the three branch channels. In the direction perpendicular to the liquid cooling plate, projections of the three first turbulence members at least partially overlap the projection of the phase-A power conversion module, the projection of the phase-B power conversion module, and the projection of the phase-C power conversion module respectively. The second turbulence member is located on the first main channel. In the direction perpendicular to the liquid cooling plate, a projection of the second turbulence member at least partially overlaps the projection of the phase-N power conversion module. The first turbulence member and the second turbulence member are configured to disturb the coolant, and a turbulence capability of the first turbulence member is stronger than a turbulence capability of the second turbulence member.

The turbulence capability of the turbulence member is defined as follows: On a premise that other conditions such as a size of a turbulence member, a size of a channel, and a flow rate of coolant are the same, and in correspondence with a same heat source, a higher temperature of coolant flowing through the turbulence member (that is, the coolant more fully absorbs heat) indicates a stronger turbulence capability of the turbulence member. Correspondingly, the turbulence capability of the first turbulence member and the turbulence capability of the second turbulence member may be measured in the following manner: First, the first turbulence member is placed on the channel, and a heat source (for example, a power conversion module) is correspondingly disposed above the channel, to measure a temperature of coolant at the first turbulence member. Then, the first turbulence member is taken out, and the second turbulence member is placed at a same position on a same channel, to measure a temperature of coolant at the second turbulence member. If the temperature of the coolant at the first turbulence member is higher than the temperature of the coolant at the second turbulence member, it indicates that the turbulence capability of the first turbulence member is stronger than the turbulence capability of the second turbulence member.

According to the technical solution provided in the present disclosure, because a flow rate of the first main channel is greater than a flow rate of each branch channel, a heat dissipation capability of the first main channel is better than a heat dissipation capability of the branch channel on a premise that the turbulence member is not considered. In the present disclosure, the turbulence capability of the first turbulence member is set to be stronger than the turbulence capability of the second turbulence member. This improves the heat dissipation capability of the branch channel, so that the heat dissipation capability of the branch channel tends to be consistent with the heat dissipation capability of the first main channel. Further, heat dissipation effect of the phase-A power conversion module, the phase-B power conversion module, and the phase-C power conversion module is improved.

In an implementation, the first turbulence member includes a plurality of first turbulence fins, and the second turbulence member includes a plurality of second turbulence fins. A structure of the first turbulence fin is the same as a structure of the second turbulence fin, and a fin shape of the first turbulence fin facing coolant in the branch channel is different from a fin shape of the second turbulence fin facing coolant in the first main channel.

According to the technical solution provided in the present disclosure, because the structure of the first turbulence fin is the same as the structure of the second turbulence fin, the first turbulence member and the second turbulence member can be manufactured by using a same mold, to implement a co-mold design, and there is no need to develop two sets of molds, which reduces manufacturing costs of the liquid cooling plate. In addition, the fin shape of the first turbulence fin facing the coolant in the branch channel is set to be different from the fin shape of the second turbulence fin facing the coolant in the first main channel. In this way, the turbulence capability of the first turbulence member can also be stronger than the turbulence capability of the second turbulence member.

In an implementation, in a flow direction of the first main channel, a projection pattern of the second turbulence fin is in a U shape or an inverted U shape. In a flow direction of the branch channel, a projection pattern of the first turbulence fin is a long strip.

In an implementation, cross sections of both the first turbulence fin and the second turbulence fin are in a shape of a rhombus, and the rhombus has two obtuse angles and two acute angles. The two obtuse angles corresponding to the first turbulence fin are sequentially arranged in a flow direction of the branch channel. The two acute angles corresponding to the second turbulence fin are sequentially arranged in a flow direction of the first main channel. A turbulence capability of the obtuse angle is stronger than a turbulence capability of the acute angle. Therefore, a turbulence capability of a single first turbulence fin is stronger than a turbulence capability of a single second turbulence fin. This helps implement that the turbulence capability of the first turbulence member is stronger than the turbulence capability of the second turbulence member.

In an implementation, in a direction perpendicular to the flow direction of the branch channel, a spacing between two adjacent first turbulence fins is a first spacing. In a direction perpendicular to the flow direction of the first main channel, a spacing between two adjacent second turbulence fins is a second spacing. The first spacing is less than or equal to the second spacing. A smaller spacing between the turbulence fins indicates a stronger turbulence capability of the turbulence member. Therefore, the first spacing is set to be less than or equal to the second spacing. This helps implement that the turbulence capability of the first turbulence member is stronger than the turbulence capability of the second turbulence member.

In an implementation, the plurality of power conversion modules include a phase-A power conversion module, a phase-B power conversion module, a phase-C power conversion module, and a phase-N power conversion module. The inside of the liquid cooling plate includes four branch channels. In the direction perpendicular to the liquid cooling plate, a projection of the phase-A power conversion module, a projection of the phase-B power conversion module, a projection of the phase-C power conversion module, and a projection of the phase-N power conversion module at least partially overlap projections of the four branch channels respectively. In this way, coolant in the four branch channels separately flows through regions corresponding to the power conversion modules, and separately takes away heat of the power conversion modules. In this way, heat dissipation of one power conversion module is not affected by heat dissipated by any other power conversion module, and each power conversion module has good heat dissipation effect.

According to a second aspect, the present disclosure provides an energy storage cabinet. The energy storage cabinet includes a power conversion device, a battery pack, a cabinet body, and a liquid cooling pipeline. The power conversion device is the power conversion device according to any implementation of the first aspect. The power conversion device and the battery pack are located inside the cabinet body. The liquid cooling pipeline communicates with the liquid cooling plate of the power conversion device and a liquid cooling plate of the battery pack. In this way, both the battery pack and the power conversion device have good heat dissipation effect.

### BRIEF DESCRIPTION OF DRAWINGS

FIG. 1 is an exploded view of a power conversion device according to an embodiment of the present disclosure;
FIG. 2 is a diagram of a liquid cooling plate, a power plate, an inductor module, and an intra-cavity heat sink according to an embodiment of the present disclosure;
FIG. 3 is a diagram of a liquid cooling plate according to an embodiment of the present disclosure;
FIG. 4 is a diagram of a channel of a liquid cooling plate according to an embodiment of the present disclosure;
FIG. 5 is a diagram of a channel of a liquid cooling plate according to an embodiment of the present disclosure;
FIG. 6 is a diagram of a relative position relationship between a channel of a liquid cooling plate and an electronic component according to an embodiment of the present disclosure;
FIG. 7 is a diagram of a turbulence member according to an embodiment of the present disclosure;
FIG. 8 is a diagram of a first turbulence member and a branch channel according to an embodiment of the present disclosure;
FIG. 9 is a diagram of a second turbulence member and a first main channel according to an embodiment of the present disclosure;
FIG. 10 is a diagram of a turbulence member according to an embodiment of the present disclosure;
FIG. 11 is a diagram of a first turbulence member and a branch channel according to an embodiment of the present disclosure;
FIG. 12 is a diagram of a second turbulence member and a first main channel according to an embodiment of the present disclosure; and
FIG. 13 is a diagram of an energy storage cabinet according to an embodiment of the present disclosure.

### Description of reference numerals:

100: power conversion device; 200: battery pack; 300: cabinet body; 400: liquid cooling pipeline; 401: liquid inlet pipeline; 402: liquid outlet pipeline;
1: housing;
2: power plate; 21: phase-A power conversion module; 22: phase-B power conversion module; 23: phase-C power conversion module; 24: phase-N power conversion module; 25: balanced circuit; 26: anti-reverse module;
3: liquid cooling plate; 30: nozzle; 301: liquid inlet; 302: liquid outlet; 31: substrate; 311: first main channel; 312: branch channel; 313: second main channel; 32: cover plate; 33: first turbulence member; 331: first turbulence fin; 332: first bottom plate; 34: second turbulence member; 341: second turbulence fin; 342: second bottom plate;
4: inductor assembly; 41: inverter inductor; 42: balanced inductor;
5: intra-cavity heat sink;
6: capacitor plate; and
7: output plate.

### DESCRIPTION OF EMBODIMENTS

With development of the new energy industry, a power of a power conversion device continuously increases, and power consumption of an electronic component inside the power conversion device also continuously increases. Currently, air cooling for heat dissipation is a main heat dissipation technology route of the power conversion device, and liquid cooling for heat dissipation is less used. As power density of the power conversion device increases, an overload requirement arises, and the like, heat dissipation density of air cooling cannot meet a heat dissipation requirement of the power conversion device. A technical solution of liquid cooling for heat dissipation has characteristics of high heat flux density and low costs, and therefore is gradually applied to the power conversion device. In the technical solution of liquid cooling for heat dissipation, a liquid cooling plate is a key component, and a design solution of the liquid cooling plate determines a heat dissipation capability and costs of a system.

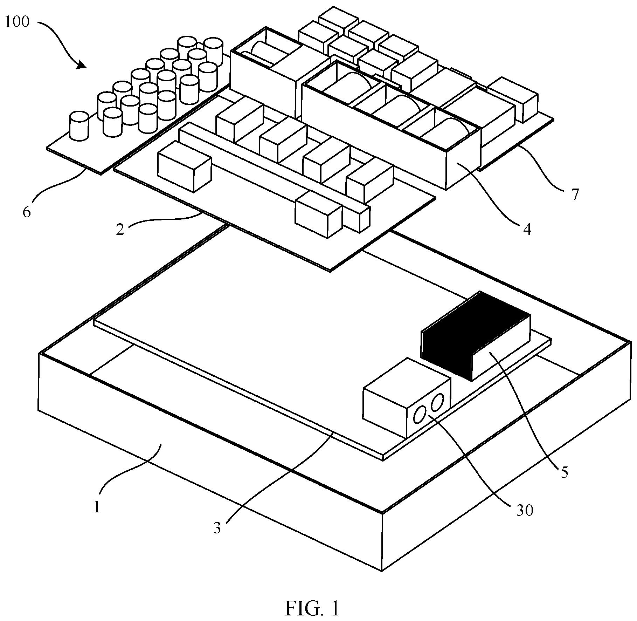

As shown in FIG. 1, a power conversion device 100 includes a housing 1, a power plate 2, a liquid cooling plate 3, an inductor assembly 4, an intra-cavity heat sink 5, a capacitor plate 6, and an output plate 7. The liquid cooling plate 3 is attached to the power plate 2, the inductor assembly 4, and the intra-cavity heat sink 5. The liquid cooling plate 3 is configured to dissipate heat for the power plate 2, the inductor assembly 4, and the intra-cavity heat sink 5. The capacitor plate 6 and the output plate 7 are applicable to air cooling heat dissipation. Cold air is turned into hot air after blowing to the capacitor plate 6 and the output plate 7. The hot air exchanges heat with the intra-cavity heat sink 5, and heat of the intra-cavity heat sink 5 is dissipated by using the liquid cooling plate 3.

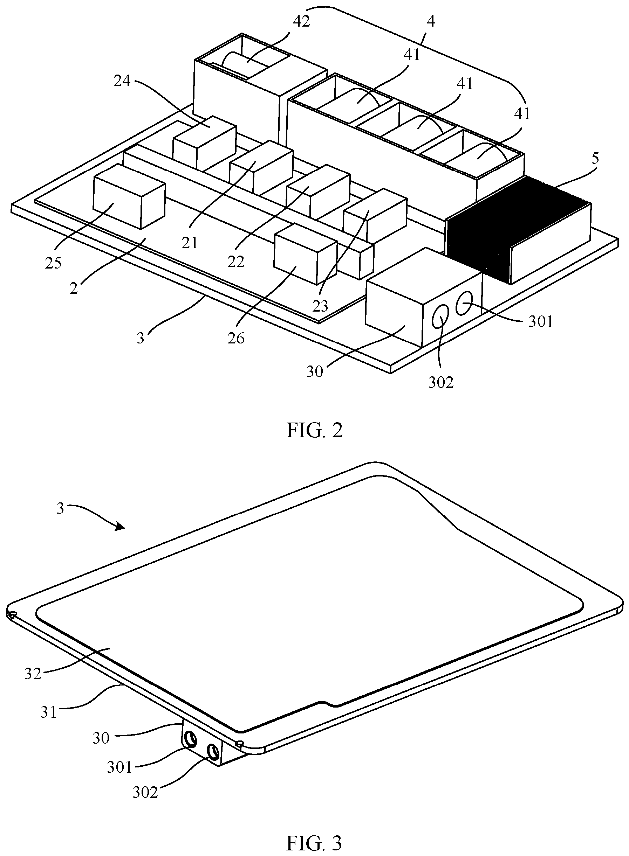

As shown in FIG. 2, one side of the power plate 2 includes a plurality of power conversion modules (a phase-A power conversion module 21, a phase-B power conversion module 22, a phase-C power conversion module 23, and a phase-N power conversion module 24), a balanced circuit 25, and an anti-reverse module 26, and the other side of the power plate 2 is attached to the liquid cooling plate 3. In addition, the inductor assembly 4 and the intra-cavity heat sink 5 are also attached to the liquid cooling plate 3. The inductor assembly 4 includes three inverter inductors 41 and a balanced inductor 42.

In a related technology, the inside of the liquid cooling plate 3 includes a channel (not shown in the figure), and coolant in the channel sequentially flows through regions corresponding to electronic components. Specifically, the coolant sequentially flows through regions corresponding to the intra-cavity heat sink 5, the three inverter inductors 41, the balanced inductor 42, the phase-N power conversion module 24, the balanced circuit 25, the phase-A power conversion module 21, the phase-B power conversion module 22, the phase-C power conversion module 23, and the anti-reverse module 26. Heat flux density in the region corresponding to the power conversion module is the most concentrated, and heat dissipation load is the largest.

Because the coolant sequentially flows through the regions corresponding to the electronic components, a temperature of the coolant continuously increases in a flow process, which causes heat dissipation of downstream electronic components to deteriorate. The power conversion module is used as an example. For the phase-C power conversion module 23, the coolant first flows through the regions corresponding to the phase-N power conversion module 24, the phase-A power conversion module 21, and the phase-B power conversion module 22, and then flows through the region corresponding to the phase-C power conversion module 23. In this way, when the coolant flows to the phase-C power conversion module 23, the temperature is already high, and heat dissipation efficiency of the phase-C power conversion module 23 is low. This phenomenon may also be referred to as a phenomenon of thermal cascading.

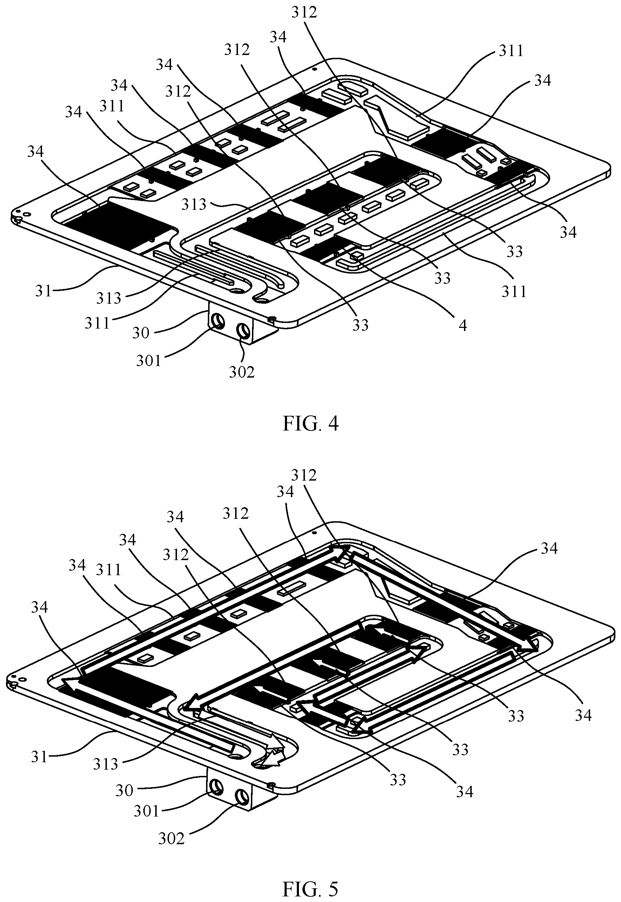

In view of the foregoing technical problem, an embodiment of the present disclosure provides a new power conversion device 100. As shown in FIG. 3 and FIG. 4, the inside of the liquid cooling plate 3 in the power conversion device 100 includes a first main channel 311, a plurality of branch channels 312, and a second main channel 313. Two ends of each branch channel 312 respectively communicate with the first main channel 311 and the second main channel 313. The plurality of branch channels 312 are disposed in parallel.

As shown in FIG. 3 and FIG. 4, the liquid cooling plate 3 includes a substrate 31 and a cover plate 32. One of the substrate 31 and the cover plate 32 is provided with a groove, and the other closes the groove. A groove wall of the groove and a plate surface of the other plate body are enclosed to form a channel. The substrate 31 is a thick plate body on the liquid cooling plate 3, and the cover plate 32 is a thin plate body on the liquid cooling plate 3. The substrate 31 and the cover plate 32 may be fastened together through welding (for example, brazing). Both the substrate 31 and the cover plate 32 may be aluminum plates.

In this embodiment of the present disclosure, which one of the substrate 31 and the cover plate 32 is provided with the groove is not limited. In some examples, as shown in FIG. 4, the substrate 31 is provided with the groove, and the cover plate 32 closes the groove. The groove on the substrate 31 may be formed through machining. In some other examples, the cover plate 32 is provided with the groove (not shown in the figure), and the substrate 31 closes the groove. Because the cover plate 32 is thin, the groove on the cover plate 32 may be formed by using a stamping process. The stamping process has advantages of fast speed and low costs when the liquid cooling plate 3 is manufactured in a large quantity.

In some examples, as shown in FIG. 1 to FIG. 4, the liquid cooling plate 3 further includes a nozzle 30, and the nozzle 30 is fastened on the substrate 31 or the cover plate 32. The nozzle 30 includes a liquid inlet 301 and a liquid outlet 302. As shown in FIG. 4, the liquid inlet 301 communicates with one end of the first main channel 311, and the liquid outlet 302 communicates with one end of the second main channel 313. The liquid inlet 301 and the liquid outlet 302 of the nozzle 30 are configured to connect to an external liquid cooling pipeline, so that cooled coolant enters the inside of the liquid cooling plate 3 through the liquid inlet 301, and heated coolant flows out through the liquid outlet 302. The heated coolant is cooled after flowing out through the liquid outlet 302, and then is input into the inside of the liquid cooling plate 3 through the liquid inlet 301 again, thereby implementing circulation of the coolant.

FIG. 5 is a diagram of a flow path of the coolant in the inside of the liquid cooling plate 3. As shown in FIG. 5, the coolant flows into the inside of the first main channel 311 from the liquid inlet 301 of the nozzle 30, and then separately flows through the plurality of branch channels 312. The coolant flowing out from the plurality of branch channels 312 converges on the second main channel 313, and then flows out through the liquid outlet 302 of the nozzle 30.

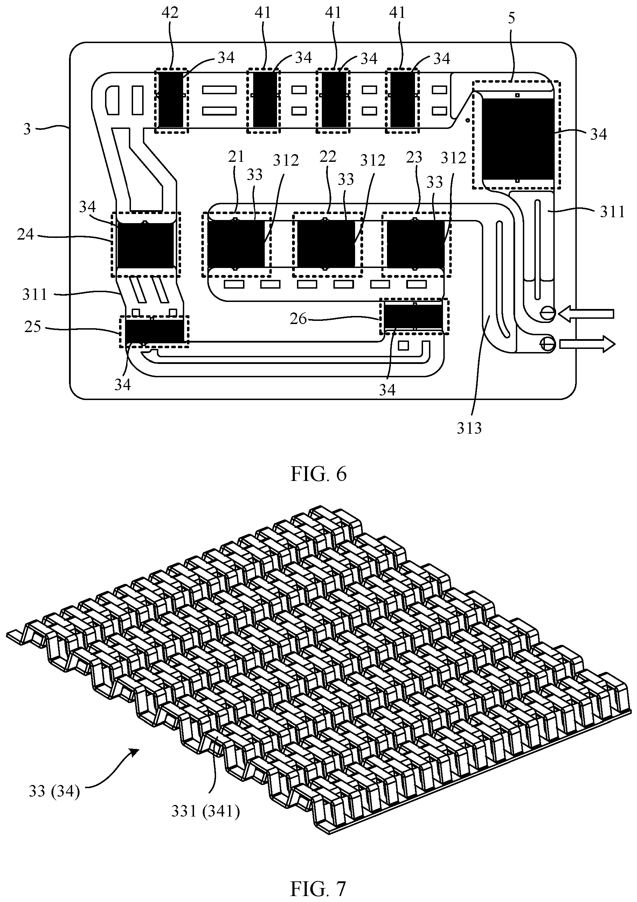

FIG. 6 is a diagram of a correspondence between each electronic component in the power conversion device 100 and the channel on the liquid cooling plate 3. As shown in FIG. 6, in a direction perpendicular to the liquid cooling plate 3, a projection of the phase-A power conversion module 21, a projection of the phase-B power conversion module 22, and a projection of the phase-C power conversion module 23 at least partially overlap projections of three branch channels 312 respectively. In this way, the coolant separately flows through the regions corresponding to the phase-A power conversion module 21, the phase-B power conversion module 22, and the phase-C power conversion module 23, and separately takes away heat of the phase-A power conversion module 21, the phase-B power conversion module 22, and the phase-C power conversion module 23. In this way, heat dissipation of one power conversion module is not affected by the heat dissipated by the other two power conversion modules. This reduces impact of thermal cascading, and improves heat dissipation efficiency of the phase-A power conversion module 21, the phase-B power conversion module 22, and the phase-C power conversion module 23.

In some other examples, as shown in FIG. 6, in the direction perpendicular to the liquid cooling plate 3, a projection of the phase-N power conversion module 24 at least partially overlaps a projection of the first main channel 311. Power consumption and a temperature of the phase-N power conversion module 24 are higher than power consumption and temperatures of the phase-A power conversion module 21, the phase-B power conversion module 22, and the phase-C power conversion module 23. Specifically, working duration of the phase-N power conversion module 24 is longer than working duration of the other power conversion modules.

As shown in FIG. 6, the coolant first flows through the region corresponding to the phase-N power conversion module 24, and then separately flows through the regions corresponding to the phase-A power conversion module 21, the phase-B power conversion module 22, and the phase-C power conversion module 23. In this way, heat dissipation of the phase-N power conversion module 24 is not affected by heat dissipation of the other power conversion modules. Because power consumption and the temperature of the phase-N power conversion module 24 are higher than power consumption and the temperatures of the other phase power conversion modules, this design can ensure heat dissipation effect of the phase-N power conversion module 24 with higher power consumption.

In some other examples, the inside of the liquid cooling plate 3 includes four branch channels 312 (not shown in the figure). In addition, in the direction perpendicular to the liquid cooling plate 3, the projection of the phase-A power conversion module 21, the projection of the phase-B power conversion module 22, the projection of the phase-C power conversion module 23, and the projection of the phase-N power conversion module 24 at least partially overlap projections of the four branch channels 312 respectively. In this way, the coolant separately flows through the regions corresponding to the phase-A power conversion module 21, the phase-B power conversion module 22, the phase-C power conversion module 23, and the phase-N power conversion module 24. In this way, heat dissipation of any one of the phase-A power conversion module 21, the phase-B power conversion module 22, the phase-C power conversion module 23, and the phase-N power conversion module 24 is not affected by heat dissipated by the other three power conversion modules. This reduces impact of thermal cascading, so that each power conversion module has high heat dissipation efficiency.

In some examples, because power consumption and the temperature of the phase-N power conversion module 24 are higher, a flow rate of a branch channel 312 corresponding to the phase-N power conversion module 24 is set to be greater than flow rates of the other three branch channels 312, so that a heat dissipation capability of the branch channel 312 corresponding to the phase-N power conversion module 24 is higher.

In some other examples, the inside of the liquid cooling plate 3 includes two branch channels 312. In addition, in the direction perpendicular to the liquid cooling plate 3, projections of two power conversion modules (for example, the phase N power conversion module and the phase A power conversion module) partially overlap a projection of one branch channel 312, and projections of the other two power conversion modules (for example, the phase B power conversion module and the phase C power conversion module) partially overlap a projection of the other branch channel 312 (not shown in the figure). In this way, heat dissipation of each power conversion module is affected by heat dissipated by a maximum of one power conversion module. This also reduces impact of thermal cascading, and improves heat dissipation efficiency of the power conversion module.

It should be noted that the foregoing technical solutions may be summarized as follows: Projections of at least two of the plurality of power conversion modules at least partially overlap projections of the different branch channels 312. In this way, coolant in different branch channels 312 respectively take away heat of the at least two power conversion modules. In this way, heat dissipation of the power conversion modules corresponding to the different branch channels 312 does not affect each other. This reduces impact of thermal cascading, and improves heat dissipation efficiency of the power conversion modules.

In some examples, as shown in FIG. 6, the one side of the power plate 2 further includes a balanced circuit 25 and an anti-reverse module 26. In the direction perpendicular to the liquid cooling plate 3, a projection of the balanced circuit 25 and a projection of the anti-reverse module 26 at least partially overlap the projection of the first main channel 311. In this way, the coolant first flows through regions corresponding to the balanced circuit 25 and the anti-reverse module 26, and then separately flows through the regions corresponding to the phase-A power conversion module 21, the phase-B power conversion module 22, and the phase-C power conversion module 23. Therefore, a temperature of the coolant flowing through the regions corresponding to the balanced circuit 25 and the anti-reverse module 26 is low. This helps improve heat dissipation effect of the balanced circuit 25 and the anti-reverse module 26. In addition, because power consumption of the balanced circuit 25 and the anti-reverse module 26 is far lower than power consumption of the power conversion module, heat dissipated by the balanced circuit 25 and the anti-reverse module 26 causes a small temperature increase of the coolant, and also has small impact on heat dissipation of the phase-A power conversion module 21, the phase-B power conversion module 22, and the phase-C power conversion module 23.

In this embodiment of the present disclosure, whether the coolant first flows through the regions corresponding to the balanced circuit 25 and the anti-reverse module 26, or first flows through the region corresponding to the phase-N power conversion module 24 is not limited. In some examples, the coolant first flows through regions corresponding to the balanced circuit 25 and the anti-reverse module 26, and then flows through the region corresponding to the phase-N power conversion module 24. In this way, impact of heat dissipated by the phase-N power conversion module 24 on heat dissipation of the balanced circuit 25 and the anti-reverse module 26 can be reduced. In addition, because power consumption of the balanced circuit 25 and the anti-reverse module 26 is low, the phase-N power conversion module 24 is not greatly affected.

In some other examples, as shown in FIG. 6, limited by a layout of each electronic component on the power plate 2, alternatively, the coolant may first flow through the region corresponding to the phase-N power conversion module 24, and then flow through regions corresponding to the balanced circuit 25 and the anti-reverse module 26. In this way, compared with a technical solution, in a related technology, in which the anti-reverse module 26 is located on a most downstream electronic component of all electronic components, heat dissipation efficiency of the anti-reverse module 26 in this embodiment of the present disclosure is also higher.

The following describes, when the coolant flows in the inside of the liquid cooling plate 3, a sequence of the regions that correspond to electronic components and through which the coolant flows.

As shown in FIG. 6, the coolant flows into the inside of the first main channel 311, and then sequentially flows through regions corresponding to the intra-cavity heat sink 5, the three inverter inductors 41, the balanced inductor 42, the phase-N power conversion module 24, the balanced circuit 25, and the anti-reverse module 26. Then, the coolant separately flows into the three branch channels 312, and then flows through the regions corresponding to the phase-A power conversion module 21, the phase-B power conversion module 22, and the phase-C power conversion module 23. Finally, the coolant in the three branch channel 312 flows into the second main channel 313, and then flows out through the liquid outlet 302 of the nozzle 30.

In some examples, as shown in FIG. 4 to FIG. 6, the liquid cooling plate 3 further includes three first turbulence members 33. The three first turbulence members 33 are respectively located on the three branch channels 312. As shown in FIG. 6, in the direction perpendicular to the liquid cooling plate 3, projections of the three first turbulence members 33 at least partially overlap the projection of the phase-A power conversion module 21, the projection of the phase-B power conversion module 22, and the projection of the phase-C power conversion module 23 respectively.

The first turbulence member 33 is configured to disturb the coolant in the branch channel 312, so that the coolant can more fully absorb heat in a region in which the first turbulence member 33 is located. This improves a convective heat exchange capability and a convective mixing capability of the coolant.

According to the technical solution provided in this embodiment of the present disclosure, because the plurality of branch channels 312 are disposed in parallel, a flow rate of each branch channel 312 is smaller than a flow rate of the first main channel 311. A sum of the flow rates of the plurality of branch channels 312 is equal to the flow rate of the first main channel 311. A decrease of the flow rate causes a decrease of a heat dissipation capability of each branch channel 312. However, the first turbulence member 33 is disposed on each branch channel 312, so that a local heat dissipation capability of each branch channel 312 is improved, a heat dissipation capability decrease caused by a flow rate decrease of each branch channel 312 is compensated, and heat dissipation efficiency of the phase-A power conversion module 21, the phase-B power conversion module 22, and the phase-C power conversion module 23 is improved.

In some examples, as shown in FIG. 4 to FIG. 6, the liquid cooling plate 3 further includes a second turbulence member 34, and the second turbulence member 34 is located on the first main channel 311. As shown in FIG. 6, in the direction perpendicular to the liquid cooling plate 3, a projection of the second turbulence member 34 at least partially overlaps the projection of the phase-N power conversion module 24.

The second turbulence member 34 is configured to disturb the coolant in the first main channel 311, so that the coolant can more fully absorb heat in a region in which the second turbulence member 34 is located. This improves the convective heat exchange capability and the convective mixing capability of the coolant.

In addition, because the flow rate of the first main channel 311 is greater than the flow rate of each branch channel 312, a heat dissipation capability of the first main channel 311 is better than the heat dissipation capability of the branch channel 312 on a premise that the turbulence member is not considered. To enable the heat dissipation capability of the branch channel 312 to be close to the heat dissipation capability of the first main channel 311, in some examples, a turbulence capability of the first turbulence member 33 is set to be stronger than a turbulence capability of the second turbulence member 34.

The turbulence capability of the turbulence member may be defined as follows: On a premise that other conditions such as a size of a turbulence member, a size of a channel, and a flow rate of coolant are the same, and in correspondence with a same heat source, a higher temperature of coolant flowing through the turbulence member (that is, the coolant more fully absorbs heat) indicates a stronger turbulence capability of the turbulence member.

Correspondingly, the turbulence capability of the first turbulence member 33 and the turbulence capability of the second turbulence member 34 may be measured in the following manner: First, the first turbulence member 33 is placed on the channel, and a heat source is correspondingly disposed above the channel, to measure a temperature of coolant at the first turbulence member 33. Then, the first turbulence member 33 is taken out, and the second turbulence member 34 is placed at a same position on a same channel, to measure a temperature of coolant at the second turbulence member 34. If the temperature of the coolant at the first turbulence member 33 is higher than the temperature of the coolant at the second turbulence member 34, it indicates that the turbulence capability of the first turbulence member 33 is stronger than the turbulence capability of the second turbulence member 34.

It should be noted that a groove may be disposed at a position corresponding to the turbulence member on a plate body (the substrate 31 or the cover plate 32) of the liquid cooling plate 3, and a temperature sensor is placed in the groove. A temperature measured by the temperature sensor represents the temperature of the coolant.

In some examples, as shown in FIG. 6, there are a plurality of second turbulence members 34. In the direction perpendicular to the liquid cooling plate 3, projections of the plurality of second turbulence members 34 at least partially overlap a projection of the intra-cavity heat sink 5, projections of the three inverter inductors 41, a projection of the balanced inductor 42, a projection of the balanced circuit 25, a projection of the anti-reverse module 26, and the projection of the phase-N power conversion module 24 respectively. In this way, heat dissipation effect of the intra-cavity heat sink 5, the three inverter inductors 41, the balanced inductor 42, the balanced circuit 25, the anti-reverse module 26, and the phase-N power conversion module 24 is improved.

An implementation in which the turbulence capability of the first turbulence member 33 is stronger than the turbulence capability of the second turbulence member 34 is not limited in embodiments of the present disclosure. In some examples, two types of turbulence members of different structures are disposed, a turbulence member with a strong turbulence capability is used as the first turbulence member 33, and a turbulence member with a weak turbulence capability is used as the second turbulence member 34.

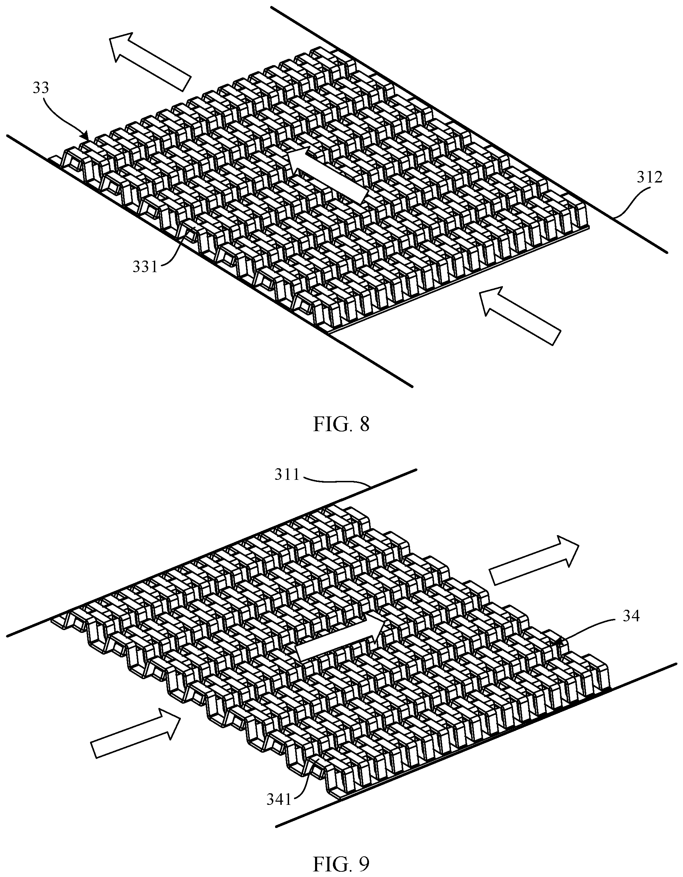

In some other examples, turbulence members of a same structure are disposed, and the turbulence capability of the turbulence member is changed by changing a pose of the turbulence member on the channel. For example, as shown in FIG. 7 to FIG. 9 or FIG. 10 to FIG. 12, the first turbulence member 33 includes a plurality of first turbulence fins 331, and the second turbulence member 34 includes a plurality of second turbulence fins 341. A structure of the first turbulence fin 331 is the same as a structure of the second turbulence fin 341, and a fin shape of the first turbulence fin 331 facing the coolant in the branch channel 312 is different from a fin shape of the second turbulence fin 341 facing the coolant in the first main channel 311.

In this way, the first turbulence member 33 and the second turbulence member 34 include the turbulence fins of a same structure, so that the first turbulence member 33 and the second turbulence member 34 can be designed by using a same mold, and there is no need to develop two sets of molds, which reduces costs. In addition, the fin shape of the first turbulence fin 331 facing the coolant in the branch channel 312 is set to be different from the fin shape of the second turbulence fin 341 facing the coolant in the first main channel 311. In this way, the turbulence capability of the first turbulence member 33 can be stronger than the turbulence capability of the second turbulence member 34.

The following describes the fin shapes of the first turbulence fin 331 and the second turbulence fin 341 by using examples.

In some examples, as shown in FIG. 7 to FIG. 9, in a flow direction of the first main channel 311, a projection pattern of the second turbulence fin 341 is in a U shape or an inverted U shape. In a flow direction of the branch channel 312, a projection pattern of the first turbulence fin 331 is a long strip, and one end of the long strip points to the substrate 31, and the other end points to the cover plate 32.

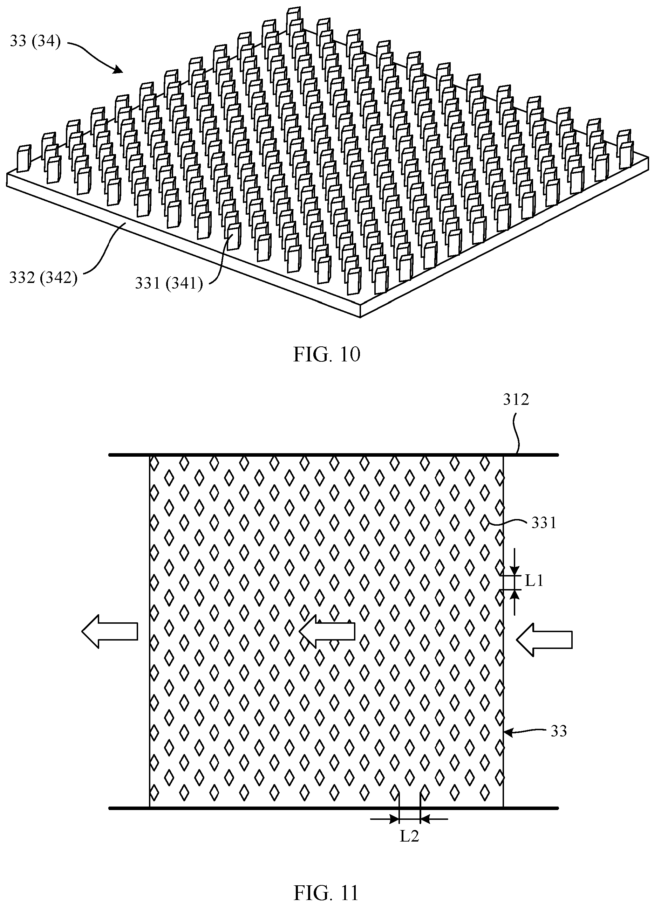

In some examples, as shown in FIG. 10 to FIG. 12, cross sections of both the first turbulence fin 331 and the second turbulence fin 341 are in a shape of a rhombus, and the rhombus has two obtuse angles and two acute angles. The two obtuse angles corresponding to the first turbulence fin 331 are sequentially arranged in a flow direction of the branch channel 312. The two acute angles corresponding to the second turbulence fin 341 are sequentially arranged in a flow direction of the first main channel 311. Because a turbulence capability of the obtuse angle is stronger than a turbulence capability of the acute angle, a turbulence capability of a single first turbulence fin 331 is stronger than a turbulence capability of a single second turbulence fin 341. This helps implement that the turbulence capability of the first turbulence member 33 is stronger than the turbulence capability of the second turbulence member 34.

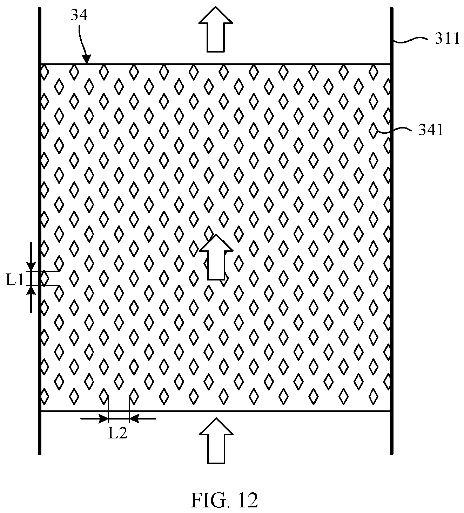

In some examples, as shown in FIG. 11, in a direction perpendicular to the flow direction of the branch channel 312, a spacing between two adjacent first turbulence fins 331 is a first spacing L1. As shown in FIG. 12, in a direction perpendicular to the flow direction of the first main channel 311, a spacing between two adjacent second turbulence fins 341 is a second spacing L2. The first spacing L1 is less than or equal to the second spacing L2. A smaller spacing between the turbulence fins indicates a stronger turbulence capability of the turbulence member. Therefore, the first spacing L1 is set to be less than or equal to the second spacing L2. This also helps implement that the turbulence capability of the first turbulence member 33 is stronger than the turbulence capability of the second turbulence member 34.

Certainly, in some other examples, the first spacing L1 may also be greater than the second spacing L2. This is not limited in embodiments of the present disclosure.

In some examples, as shown in FIG. 10, the first turbulence member 33 includes a first bottom plate 332, and the plurality of first turbulence fins 331 are fastened on a same surface of the first bottom plate 332. The second turbulence member 34 includes a second bottom plate 342, and the plurality of second turbulence fins 341 are fastened on a same surface of the second bottom plate 342. A thickness of the first bottom plate 332 is the same as a thickness of the second bottom plate 342. Certainly, as shown in FIG. 7, the turbulence member may alternatively not include a bottom plate, and the turbulence fins are connected to each other to form the turbulence member.

In this embodiment of the present disclosure, a manner of mounting the turbulence member (the first turbulence member 33 or the second turbulence member 34) on the substrate 31 or the cover plate 32 is not limited. In some examples, the turbulence member is manufactured independent of the substrate 31 or the cover plate 32, and the turbulence member is fastened on the substrate 31 or the cover plate 32. For example, the turbulence member is welded on the substrate 31 or the cover plate 32. In some other examples, the turbulence member is integrally formed on the substrate 31. For example, a channel and a turbulence member are processed on the substrate 31 through machining.

It should be noted that the turbulence member may also be referred to as an enhanced heat dissipation fin, or the like.

A specific type of the power conversion device 100 is not limited in embodiments of the present disclosure. In some examples, the power conversion device 100 is a power conversion system (power conversion system, PCS), an inverter, or the like. The PCS is used as an example. The PCS is a bidirectional current controllable conversion device that connects an energy storage battery and a power grid (or a load), and is configured to control charging and discharging processes of the energy storage battery, and perform alternating current/direct current conversion. The PCS can accurately and quickly adjust a voltage, a frequency, and a power between the power grid and an energy storage system, to implement charging and discharging at a constant power and a constant current and a smooth and fluctuating power output.

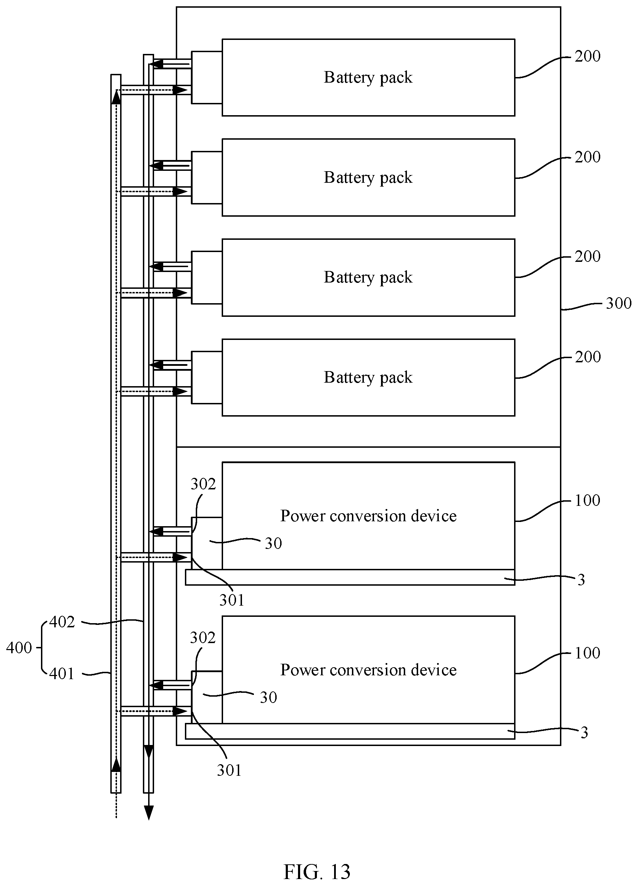

An embodiment of the present disclosure further provides an energy storage cabinet. As shown in FIG. 13, the energy storage cabinet includes a power conversion device 100, a battery pack 200, a cabinet body 300, and a liquid cooling pipeline 400. The power conversion device 100 and the battery pack 200 are located inside the cabinet body 300. The liquid cooling pipeline 400 communicates with the liquid cooling plate 3 of the power conversion device 100 and a liquid cooling plate of the battery pack 200. In this way, the power conversion device 100 and the battery pack 200 use liquid cooling for heat dissipation, and heat dissipation effect is high.

In some examples, as shown in FIG. 13, the liquid cooling pipeline 400 includes a liquid inlet pipeline 401 and a liquid outlet pipeline 402. The liquid inlet pipeline 401 communicates with a liquid inlet 301 of a nozzle 30 on the liquid cooling plate 3. The liquid outlet pipeline 402 communicates with a liquid outlet 302 of the nozzle 30 on the liquid cooling plate 3. Coolant in the liquid inlet pipeline 401 flows into the inside of the liquid cooling plate 3 through the liquid inlet 301 of the nozzle 30, and the coolant flows along an internal channel of the liquid cooling plate 3. Then, the coolant flows into the liquid outlet pipeline 402 through the liquid outlet 302 of the nozzle 30, and flows out through the liquid outlet pipeline 402.

Terms used in implementations of the present disclosure are merely used to explain embodiments of the present disclosure, but are not intended to limit the present disclosure. Unless otherwise defined, technical terms or scientific terms used in implementations of the present disclosure should have the common meanings understood by a person of ordinary skill in the art to which the present disclosure pertains. The foregoing descriptions are merely optional embodiments of the present disclosure, but are not intended to limit the present disclosure. Any modification, equivalent replacement, improvement, or the like made within the principle of the present disclosure should fall within the protection scope of the present disclosure.

## Claims

1. A power conversion device, wherein the power conversion device (100) comprises a housing (1), a power plate (2), and a liquid cooling plate (3);
the power plate (2) is located inside the housing (1), one side of the power plate (2) comprises a plurality of power conversion modules, and the other side of the power plate (2) is attached to the liquid cooling plate (3);
the inside of the liquid cooling plate (3) comprises a first main channel (311), at least two branch channels (312), and a second main channel (313), and two ends of each branch channel (312) respectively communicate with the first main channel (311) and the second main channel (313); and
in a direction perpendicular to the liquid cooling plate (3), projections of at least two of the plurality of power conversion modules at least partially overlap projections of the different branch channels (312).

2. The power conversion device according to claim 1, wherein the plurality of power conversion modules comprise a phase-A power conversion module (21), a phase-B power conversion module (22), and a phase-C power conversion module (23); and
the inside of the liquid cooling plate (3) comprises three branch channels (312), and in the direction perpendicular to the liquid cooling plate (3), a projection of the phase-A power conversion module (21), a projection of the phase-B power conversion module (22), and a projection of the phase-C power conversion module (23) at least partially overlap projections of the three branch channels (312) respectively.

3. The power conversion device according to claim 2, wherein coolant in the liquid cooling plate (3) sequentially flows through the first main channel (311), the three branch channels (312), and the second main channel (313); and
the plurality of power conversion modules further comprise a phase-N power conversion module (24), and in the direction perpendicular to the liquid cooling plate (3), a projection of the phase-N power conversion module (24) at least partially overlaps a projection of the first main channel (311).

4. The power conversion device according to claim 2 or 3, wherein the coolant in the liquid cooling plate (3) sequentially flows through the first main channel (311), the three branch channels (312), and the second main channel (313); and
the one side of the power plate (2) further comprises a balanced circuit (25) and an anti-reverse module (26), and in the direction perpendicular to the liquid cooling plate (3), a projection of the balanced circuit (25) and a projection of the anti-reverse module (26) at least partially overlap the projection of the first main channel (311).

5. The power conversion device according to claim 3, wherein the liquid cooling plate (3) further comprises three first turbulence members (33) and a second turbulence member (34);
the three first turbulence members (33) are respectively located on the three branch channels (312), and in the direction perpendicular to the liquid cooling plate (3), projections of the three first turbulence members (33) at least partially overlap the projection of the phase-A power conversion module (21), the projection of the phase-B power conversion module (22), and the projection of the phase-C power conversion module (23) respectively;
the second turbulence member (34) is located on the first main channel (311), and in the direction perpendicular to the liquid cooling plate (3), a projection of the second turbulence member (34) at least partially overlaps the projection of the phase-N power conversion module (24); and
the first turbulence member (33) and the second turbulence member (34) are configured to disturb the coolant, and a turbulence capability of the first turbulence member (33) is stronger than a turbulence capability of the second turbulence member (34).

6. The power conversion device according to claim 5, wherein the first turbulence member (33) comprises a plurality of first turbulence fins (331), and the second turbulence member (34) comprises a plurality of second turbulence fins (341); and
a structure of the first turbulence fin (331) is the same as a structure of the second turbulence fin (341), and a fin shape of the first turbulence fin (331) facing coolant in the branch channel (312) is different from a fin shape of the second turbulence fin (341) facing coolant in the first main channel (311).

7. The power conversion device according to claim 6, wherein in a flow direction of the first main channel (311), a projection pattern of the second turbulence fin (341) is in a U shape or an inverted U shape; and
in a flow direction of the branch channel (312), a projection pattern of the first turbulence fin (331) is a long strip.

8. The power conversion device according to claim 6, wherein cross sections of both the first turbulence fin (331) and the second turbulence fin (341) are in a shape of a rhombus, and the rhombus has two obtuse angles and two acute angles;
the two obtuse angles corresponding to the first turbulence fin (331) are sequentially arranged in a flow direction of the branch channel (312); and
the two acute angles corresponding to the second turbulence fin (341) are sequentially arranged in a flow direction of the first main channel (311).

9. The power conversion device according to claim 8, wherein in a direction perpendicular to the flow direction of the branch channel (312), a spacing between two adjacent first turbulence fins (331) is a first spacing (L1);
in a direction perpendicular to the flow direction of the first main channel (311), a spacing between two adjacent second turbulence fins (341) is a second spacing (L2); and
the first spacing (L1) is less than or equal to the second spacing (L2).

10. The power conversion device according to claim 1, wherein the plurality of power conversion modules comprise a phase-A power conversion module (21), a phase-B power conversion module (22), a phase-C power conversion module (23), and a phase-N power conversion module (24), and
the inside of the liquid cooling plate (3) comprises four branch channels (312), and in the direction perpendicular to the liquid cooling plate (3), a projection of the phase-A power conversion module (21), a projection of the phase-B power conversion module (22), a projection of the phase-C power conversion module (23), and a projection of the phase-N power conversion module (24) at least partially overlap projections of the four branch channels (312) respectively.

11. An energy storage cabinet, wherein the energy storage cabinet comprises a power conversion device (100), a battery pack (200), a cabinet body (300), and a liquid cooling pipeline (400), and the power conversion device (100) is the power conversion device according to any one of claims 1 to 10;
the power conversion device (100) and the battery pack (200) are located inside the cabinet body (300); and
the liquid cooling pipeline (400) communicates with the liquid cooling plate of the power conversion device (100) and a liquid cooling plate of the battery pack (200).
